(19) Europäisches Patentamt
European Patent Office
Office européen des brevets

(11) EP 4 270 713 A1

(12) EUROPEAN PATENT APPLICATION
published in accordance with Art. 153(4) EPC

(43) Date of publication:
01.11.2023 Bulletin 2023/44

(51) International Patent Classification (IPC):
$H02J\ 7/00^{(2006.01)}$      $H01M\ 10/44^{(2006.01)}$

(21) Application number: 20966540.5

(22) Date of filing: 25.12.2020

(52) Cooperative Patent Classification (CPC):
H02J 7/007182; H02J 7/0013; H02J 7/0048;
H02J 7/0071; H02J 7/00712; H02J 7/04;
Y02E 60/10

(86) International application number:
PCT/CN2020/139214

(87) International publication number:
WO 2022/133974 (30.06.2022 Gazette 2022/26)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Ningde Amperex Technology Ltd.
Ningde, Fujian 352106 (CN)

(72) Inventors:
• GUAN, Ting
  Ningde, Fujian 352106 (CN)
• ZHU, Shan
  Ningde, Fujian 352106 (CN)
• WU, Fei
  Ningde, Fujian 352106 (CN)

(74) Representative: Klunker IP
Patentanwälte PartG mbB
Destouchesstraße 68
80796 München (DE)

(54) **CHARGING METHOD, ELECTRONIC APPARATUS, AND STORAGE MEDIUM**

(57) Embodiments of this application provide a charging method for battery. The method includes: in an n-th charging process, charging a first battery to a charge cut-off voltage $U_n$ in a charging manner; after the n-th charging process is completed, leaving the first battery standing, and obtaining an open-circuit voltage $OCV_n$ of the first battery at a standing time of $t_i$; in an m-th charging process, charging the first battery to the charge cut-off voltage $U_n$ in the charging manner, where m > n; after the m-th charging process is completed, leaving the first battery standing, and obtaining an open-circuit voltage $OCV_m$ of the first battery at the standing time of $t_i$; and under the condition of $OCV_n > OCV_m$, in an (m+1)-th charging process and subsequent charging processes, charging the first battery to a first charge cut-off voltage $U_{m+1}$ in the charging manner, where $U_{m+1} = U_n + k \times (OCV_n - OCV_m)$, and 0 < k ≤ 1. The embodiments of this application further provide an electronic apparatus and a storage medium, so as to meet a requirement for fully charging a battery and shorten a time required for charging the battery to a full charge state.

FIG. 2

**Description**

**TECHNICAL FIELD**

This application relates to the field of battery technologies, and in particular, to a charging method, an electronic apparatus, and a storage medium.

**BACKGROUND**

In existing charging methods for battery, when a charge cut-off current is relatively large, it is likely that a battery cannot be charged to a full charge state as the battery is being used. The full charge state means that the battery is charged to a battery level of 100%. With the use of a battery, impedance of the battery increases constantly, and the battery will inevitably become unable to be fully charged, in contrast with a fresh state of the battery or a conventional constant-voltage charging method under a limited charge voltage (cut-off current is relatively small in the case of constant-voltage charging under a limited charge voltage), which means that charge cut-off state of charge (SOC) of the battery gradually decreases. Currently, there is no feasible solution to fully charge a battery in use without greatly prolonging the time required for charging the battery to the full charge state.

**SUMMARY**

In view of this, it is necessary to provide a charging method for battery, an electronic apparatus, and a storage medium, to meet a requirement for fully charging a battery.

An embodiment of this application provides a charging method for battery. The method includes: in an n-th charging process, charging a first battery to a charge cut-off voltage $U_n$ in a charging manner, where n is a positive integer greater than 0; after the n-th charging process is completed, leaving the first battery standing, and obtaining an open-circuit voltage $OCV_n$ of the first battery at a standing time of $t_i$; in an m-th charging process, charging the first battery to the charge cut-off voltage $U_n$ in the charging manner, where m is a positive integer, and m > n; after the m-th charging process is completed, leaving the first battery standing, and obtaining an open-circuit voltage $OCV_m$ of the first battery at the standing time of $t_i$; and under the condition of $OCV_n > OCV_m$, in an (m+1)-th charging process and subsequent charging processes, charging the first battery to a first charge cut-off voltage $U_{m+1}$ in the charging manner, where $U_{m+1} = U_n + k \times (OCV_n - OCV_m)$, and $0 < k \leq 1$.

According to some embodiments of this application, the voltage $OCV_n$ further includes a pre-stored open-circuit voltage of a second battery collected at the standing time of $t_i$ in the standing process that follows completion of the n-th charging process, where the first battery and the second battery are different batteries in a same battery system.

According to some embodiments of this application, the method further includes: under the condition of $OCV_n \leq OCV_m$, in the (m+1)-th charging process and the subsequent charging processes, charging the first battery to the charge cut-off voltage $U_n$ in the charging manner.

According to some embodiments of this application, the method further includes: in an (m+b)-th charging process, charging the first battery to the first charge cut-off voltage $U_{m+1}$ in the charging manner, where b is a positive integer greater than 1; after the (m+b)-th charging process is completed, leaving the first battery standing, and obtaining an open-circuit voltage $OCV_{m+b}$ of the first battery at the standing time of $t_i$; and under the condition of $OCV_n > OCV_{m+b}$, in an (m+b+1)-th charging process and subsequent charging processes, charging the first battery to a second charge cut-off voltage $U_{m+b+1}$ in the charging manner, where $U_{m+b+1} = U_{m+1} + k \times (OCV_n - OCV_{m+b})$, and $0 < k \leq 1$.

According to some embodiments of this application, the method further includes: under the condition of $OCV_n \leq OCV_{m+b}$, in the (m+b+1)-th charging process and the subsequent charging processes, charging the first battery to the first charge cut-off voltage $U_{m+1}$ in the charging manner.

According to some embodiments of this application, $U_{cl} \leq U_n \leq U_{cl} + 500$ mV, where $U_{cl}$ is a limited charge voltage of a battery system to which the first battery belongs.

According to some embodiments of this application, the charging manner includes N charging stages in sequence, where N is a positive integer greater than 1, and in the N-th charging stage, the first battery is charged constantly with the charge cut-off voltage.

According to some embodiments of this application, the charging manner further includes M constant-current charging stages in sequence, where M is a positive integer greater than 1. In the constant-current charging stages, after a voltage of the first battery reaches the charge cut-off voltage $U_n$, each of the subsequent constant-current charging stages is cut off by using the charge cut-off voltage $U_n$.

According to some embodiments of this application, the M constant-current charging stages are each defined as a k-th charging stages, with k=1, 2, ..., M, where a charge current of the (k+1)-th charging stage is less than a charge current of the k-th charging stage.

An embodiment of this application provides an electronic apparatus. The electronic apparatus includes a battery and a processor, where the processor is configured to execute the foregoing charging method to charge the battery.

An embodiment of this application provides a storage medium, storing at least one computer instruction, where the instruction is loaded by a processor to execute the foregoing charging method.

According to the embodiments of this application, based on an actual aging state of the battery, the charge cut-off voltage of the battery in the charging process is increased, so as to resolve the problem that with the cycling of a battery, impedance of the battery increases, and full charging cannot be implemented by using a charging method with a relatively large charge cut-off current. The charging method provided in the embodiments of this application can not only meet a requirement for fully charging a battery, but also shorten the time required for charging the battery to a full charge state, so as to improve user experience.

**BRIEF DESCRIPTION OF DRAWINGS**

FIG. 1 is a schematic diagram of an electronic apparatus according to an embodiment of this application.
FIG. 2 is a flowchart of a charging method according to an embodiment of this application.
FIG. 3 is a diagram of functional modules of a charging system according to an embodiment of this application.

Reference signs of main components

| | |
|---|---|
| Electronic apparatus | 1 |
| Charging system | 10 |
| Memory | 11 |
| Processor | 12 |
| Battery | 13 |
| Charging module | 101 |
| Obtaining module | 102 |

**DESCRIPTION OF EMBODIMENTS**

The following clearly and completely describes the technical solutions in the embodiments of this application with reference to the accompanying drawings in the embodiments of this application. Apparently, the described embodiments are some rather than all of the embodiments of this application.

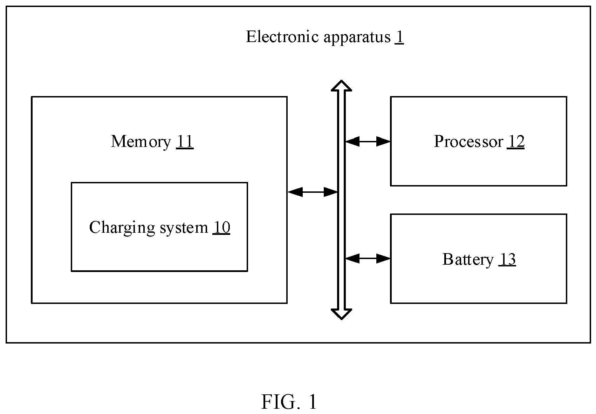

Referring to FIG. 1, FIG. 1 is a schematic diagram of an electronic apparatus according to an embodiment of this application. Referring to FIG. 1, a charging system 10 runs in an electronic apparatus 1. The electronic apparatus 1 includes, but is not limited to, a memory 11, at least one processor 12, and a battery 13 (a first battery and/or a second battery described below), where the memory 11, the at least one processor 12, and the battery 13 may be connected to one another through a bus, or may be directly connected.

In an embodiment, the battery 13 is a rechargeable battery, and is configured to supply power to the electronic apparatus 1. For example, the battery 13 may be a lithium-ion battery, a lithium polymer battery, a lithium iron phosphate battery, or the like. The battery 13 includes at least one battery cell (battery cell), and may use a recyclable and rechargeable manner. The battery 13 is logically connected to the processor 12 through a power management system, so as to implement functions such as charging, discharging, and power consumption management through the power management system.

It should be noted that, FIG. 1 only illustrates the electronic apparatus 1 by example. In other embodiments, the electronic apparatus 1 may alternatively include more or fewer components, or have different component configurations. The electronic apparatus 1 may be an electric motorcycle, an electric bicycle, an electric vehicle, a mobile phone, a tablet computer, a personal digital assistant, a personal computer, or any other appropriate rechargeable devices.

Although not shown, the electronic apparatus 1 may further include a wireless fidelity (Wireless Fidelity, Wi-Fi) unit, a Bluetooth unit, a loudspeaker, and other components. Details are not described herein again.

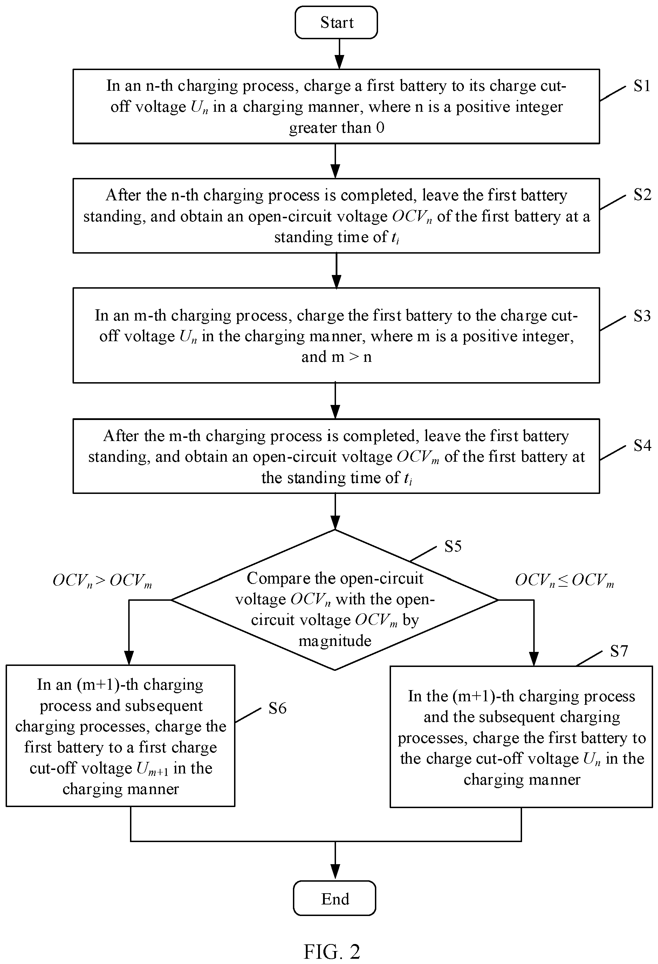

Referring to FIG. 2, FIG. 2 is a flowchart of a charging method for battery according to an embodiment of this application. Depending on different demands, the sequence of steps in the flowchart may be changed, and some steps may be omitted. Specifically, the charging method for battery may include the following steps.

Step S1: In an n-th charging process, charge a first battery to its charge cut-off voltage $U_n$ in a charging manner, where n is a positive integer greater than 0.

In an embodiment, the charging manner includes N charging stages in sequence, where N is a positive integer greater than 1, and in the N-th charging stage, the first battery is charged constantly with the charge cut-off voltage.

For example, when N = 3, the charging manner includes a first charging stage, a second charging stage, and a third charging stage. In the first charging stage, the first battery is charged to a first voltage (where the first voltage is less than the charge cut-off voltage $U_n$) constantly with a first constant current; in the second charging stage, the first battery is charged to the charge cut-off voltage $U_n$ constantly with a second constant current; and in the third charging stage, the first battery is charged constantly with the constant charge cut-off voltage $U_n$. To be specific, in the last charging stage in the charging mode, the first battery is charged constantly with the charging cut-off voltage $U_n$, and no requirement for a voltage in charging stages before the last charging stage is made.

In another embodiment, the charging manner includes M constant-current charging stages in sequence, where M is a positive integer greater than 1, the M constant-current charging stages are each defined as a k-th charging stage, with i=1, 2, ..., M, where each of the constant-current charging stages is cut off by using the charge cut-off voltage. That is, in the constant-current charging stages, after a voltage of the first battery reaches the charge cut-off voltage $U_n$, each of the subsequent constant-current charging stages is cut off by using the charge cut-off voltage $U_n$. Before the charge voltage of the first battery reaches the charge cut-off voltage $U_n$, a voltage of the first battery is not limited. For example, in the k-th charging stage, the first battery is charged to the charge cut-off voltage $U_n$ constantly with a k-th current; and in the (k+1)-th charging stage, the first battery is charged to the charge cut-off voltage $U_n$ constantly with an (k+1)-th current. It should be noted that, in charging stages before the k-th charging stage, a voltage of the first battery in a constant-current charging process is not limited; and in all charging stages after the (k+1)-th charging stage, the first battery is charged to the charge cut-off voltage $U_n$ with a constant current. For example, in the first charging stage, the first battery is charged to 4.2 V with a constant current of 3C; in the second charging stage, the first battery is charged to 4.45 V (that is, the charge cut-off voltage $U_n$) with a constant current of 2C; in the third charging stage, the first battery is charged to 4.45 V with a constant current of 1C; in the fourth charging stage, the first battery is charged to 4.45 V with a constant current of 0.5C; and in the fifth charging stage, the first battery is charged to 4.45 V with a constant current of 0.2C.

It should be noted that, in this embodiment, the charge current of the (k+1)-th charging stage is less than the charge current of the k-th charging stage.

Step S2: After the n-th charging process is completed, leave the first battery standing, and obtain an open-circuit voltage $OCV_n$ of the first battery at a standing time of $t_i$.

An actual aging state of the battery in a use process needs to be determined, and then by how much the voltage is to be increased is determined based on the actual aging state. As such, it is necessary to leave the first battery standing after the n-th charging process is completed, obtain an open-circuit voltage of the first battery during or after the standing process, and determine how much the voltage is to be increased based on the open-circuit voltage. In this application, the open-circuit voltage $OCV_n$ of the first battery at the standing time of $t_i$ is obtained.

It should be noted that, the open-circuit voltage $OCV_n$ includes an open-circuit voltage of the first battery collected at the standing time of $t_i$ in the standing process that follows completion of the n-th charging process; and the open-circuit voltage $OCV_n$ further includes a pre-stored open-circuit voltage of a second battery collected at the standing time of $t_i$ in the standing process that follows completion of the n-th charging process, where the first battery and the second battery are different batteries in a same battery system.

Step S3: In an m-th charging process, charge the first battery to the charge cut-off voltage $U_n$ in the charging manner, where m is a positive integer, and m > n.

In this embodiment, in charging processes following the n-th charging process (for example, the m-th charging process), the first battery is charged to the charge cut-off voltage $U_n$ in the same charging manner as in the n-th charging process. Then, the first battery is left standing, and an open-circuit voltage $OCV_m$ of the first battery at the same standing time of $t_i$ is obtained. Therefore, whether the charge cut-off voltage needs to be increased may be determined based on a change of the open-circuit voltage of the first battery in the charging process.

Step S4: After the m-th charging process is completed, leave the first battery standing, and obtain an open-circuit voltage $OCV_m$ of the first battery at the standing time of $t_i$.

In this embodiment, the open-circuit voltage $OCV_m$ includes an open-circuit voltage of the first battery collected at the standing time of $t_i$ in the standing process that follows completion of the m-th charging process; and the open-circuit voltage $OCV_m$ further includes a pre-stored open-circuit voltage of a second battery collected at the standing time of $t_i$ in the standing process that follows completion of the m-th charging process, where the first battery and the second battery are different batteries in a same battery system.

Step S5: Compare the open-circuit voltage $OCV_n$ with the open-circuit voltage $OCV_m$ by magnitude. Under the condition of $OCV_n > OCV_m$, it is determined that the charge cut-off current needs to be increased in subsequent charging processes, and step S6 is performed; and under the condition of $OCV_n \leq OCV_m$, it is determined that the charge cut-off current does not need to be increased in the subsequent charging processes, and step S7 is performed.

Step S6: Under the condition of $OCV_n > OCV_m$, in an (m+1)-th charging process and subsequent charging processes, charge the first battery to a first charge cut-off voltage $U_{m+1}$ in the charging manner, where $U_{m+1} = U_n + k \times (OCV_n - OCV_m)$, and $0 < k \leq 1$.

In this embodiment, under the condition of $OCV_n > OCV_m$, the charge cut-off voltage of the first battery needs to be increased. After the increase, specific magnitude of the charge cut-off voltage is determined by an actual state of the first battery. That is, in the charging process, open-circuit voltages of the first battery at the same standing time in standing processes following completion of all charging processes are collected. Based on a difference of an open-circuit voltage collected in a subsequent cyclic charging process (for example, the m-th charging process) and an open-circuit voltage collected in a previous cyclic charging process (for example, the n-th charging process), it is determined that a next charging process (for example, the (m+1)-th charging process) is to be adjusted (charged with the first charge cut-off voltage $U_{m+1}$), so as to fully charge the first battery in the cyclic charging processes without greatly prolonging the time required for fully charging the first battery. Specifically, the first charge cut-off voltage

$$U_{m+1} = U_n + k \times (OCV_n - OCV_m).$$

It should be noted that $U_{cl} \leq U_n \leq U_{cl}+500$ mV, where $U_{cl}$ is a limited charge voltage of a battery system to which the first battery belongs.

Step S7: Under the condition of $OCV_n \leq OCV_m$, in the (m+1)-th charging process and the subsequent charging processes, charge the first battery to the charge cut-off voltage $U_n$ in the charging manner.

In this embodiment, under the condition of $OCV_n \leq OCV_m$, the charge cut-off voltage of the first battery in the charging process does not need to be increased, that is, the first battery continues to be charged to the charge cut-off voltage $U_n$ in the charging manner.

It should be noted that, in cyclic charging processes following the (m+1)-th charging process, judgment on the open-circuit voltage of the first battery also needs to be performed, so as to determine whether the charge cut-off voltage of the first battery needs to be increased again. Specifically, the charging method further includes: in an (m+b)-th charging process, charging the first battery to the first charge cut-off voltage $U_{m+1}$ in the charging manner, where b is a positive integer greater than 1; after the (m+b)-th charging process is completed, leaving the first battery standing, and obtaining an open-circuit voltage $OCV_{m+b}$ of the first battery at the standing time of $t_i$; under the condition of $OCV_n > OCV_{m+b}$, in an (m+b+1)-th charging process and subsequent charging processes, charging the first battery to a second charge cut-off voltage $U_{m+b+1}$ in the charging manner, where $U_{m+b+1} = U_{m+1} + k \times (OCV_n - OCV_{m+b})$, and $0 < k \leq 1$; and under the condition of $OCV_n \leq OCV_{m+b}$, in the (m+b+1)-th charging process and the subsequent charging processes, charging the first battery to the first charge cut-off voltage $U_{m+1}$ in the charging manner.

In conclusion, in this application, the charge cut-off voltage of the battery in the charging process is increased based on the actual aging state of the battery, so as to resolve the problem that with the cycling of a battery, impedance of the battery increases, and full charging cannot be implemented by using a charging method with a relatively large charge cut-off current. For example, the charging method provided in this application can resolve a problem, with some existing fast charging methods, that with the cycling of a battery, the battery is gradually unable to be fully charged. In some fast charging methods, the charge cut-off voltage and the cut-off current of the battery are increased in the charging process. The charging method provided in this application can not only meet a requirement for fully charging a battery, but also shorten the time required for charging the battery to a full charge state, so as to improve user experience.

To make the objectives, technical solutions, and technical effects of this application clearer, the following further describes this application in detail with reference to the accompanying drawings and examples. It should be understood that the examples provided in this specification are merely intended to interpret this application, but not intended to limit this application. This application is not limited to the examples provided in this specification.

As described below, in Comparative Example 1, a charging method for increasing a voltage and a charge cut-off current of a constant-voltage charging process on the basis of a charging method (constant-current and constant-voltage charging) in the prior art is used to charge the battery (the first battery or the second battery described above). In Comparative Example 2, a charging method is used for resolving a problem, with the charging method in Comparative Example 1 that charge cut-off state of charge (SOC) gradually decreases in cyclic charging processes. In Examples 1 to 3, the charging method described in this application is used, and values of k in Examples 1 to 3 are respectively 0.5, 0.8, and 1.

**Comparative Example 1**

Ambient temperature: 25°C
Charging and discharging process:

Step 1: Charge the battery with a constant current of 3C until a voltage of the battery reaches 4.25 V;
Step 2: Charge the battery with a constant current of 2C until the voltage of the battery reaches 4.45 V;
Step 3: Charge the battery with a constant current of 1.4C until a current of the battery reaches 4.5C;
Step 4: Continue to charge the battery with a constant voltage of 4.5 V until the current of the battery reaches a cut-off current of 0.25C;
Step 5: Leave the battery standing for 1 minute;
Step 6: Then discharge the battery with a constant current of 1.0C until the voltage of the battery reaches 3.0 V;
Step 7: Then leave the battery standing for 1 minute again; and
Step 8: Repeat Step 1 to Step 7 for 500 cycles.

**Comparative Example 2**

Ambient temperature: 25°C
Charging and discharging process:

Step 1: Charge the battery with a constant current of 3C until a voltage of the battery reaches 4.25 V;
Step 2: Charge the battery with a constant current of 2C until the voltage of the battery reaches 4.45 V;
Step 3: Charge the battery with a constant current of 1.4C until the current of the battery reaches 4.5C;
Step 4: Continue to charge the battery with a constant voltage of 4.5 V until the current of the battery reaches a cut-off current of 0.25C;
Step 5: Leave the battery standing for 5 minutes;
Step 6: Charge the battery with a constant voltage of 4.45 V until the current of the battery reaches a cut-off current of 0.05C;
Step 7: Leave the battery standing for 1 minute;
Step 8: Then discharge the battery with a constant current of 1.0C until the voltage of the battery reaches 3.0 V;
Step 9: Then leave the battery standing for 1 minute again; and
Step 10: Repeat Step 1 to Step 9 for 500 cycles.

**Example 1**

Ambient temperature: 25°C
It should be noted that, Examples 1 to 3 each include a process of obtaining an open-circuit voltage $OCV_n$ and a charging and discharging process. Herein, the method for obtaining an open-circuit voltage $OCV_n$ is first described. In this embodiment, a fresh battery is selected for obtaining the parameter $OCV_n$, and specifically, the process of obtaining the open-circuit voltage $OCV_n$ is as follows:

Step 1: Charge the battery with a constant current of 3C until a voltage of the battery reaches 4.25 V;
Step 2: Charge the battery with a constant current of 2C until the voltage of the battery reaches 4.45 V;
Step 3: Charge the battery with a constant current of 1.4C until a voltage of the battery reaches 4.5V;
Step 4: Continue to charge the battery with a constant voltage of 4.5 V until the current of the battery reaches a cut-off current of 0.25C;
Step 5: Leave the battery standing for 1 minute, and collect the open-circuit voltage $OCV_n$ of the battery that has been standing for 1 minute, where a value of the open-circuit voltage is $OCV_n = 4.47\ V$.

The charging and discharging process is as follows:
Ambient temperature: 25°C

Step 1: Charge the battery with a constant current of 3C until a voltage of the battery reaches 4.25 V;
Step 2: Charge the battery with a constant current of 2C until the voltage of the battery reaches 4.45 V;
Step 3: Charge the battery with a constant current of 1.4C until the voltage of the battery reaches $U_n$, where in this case, $U_n = 4.5\ V;$

Step 4: Continue to charge the battery with a constant voltage of 4.5 V until the current of the battery reaches a cut-off current of 0.25C;

Step 5: Leave the battery standing for 1 minute, and collect the open-circuit voltage $OCV_m$ of the battery that has been standing for 1 minute;

Step 6: Then discharge the battery with a constant current of 1.0C until the voltage of the battery reaches 3.0 V;

Step 7: Then leave the battery standing for 1 minute again;

Step 8: Calculate a cut-off voltage $U_{m+1}$ of a next battery constant voltage charging, where $U_{m+1} = U_n + k \times (OCV_n - OCV_m)$, $U_n$ = 4.5 V, $OCV_n$ = 4.47 V, and k=0.5;

Step 9: Charge the battery with a constant current of 3C until the voltage of the battery reaches 4.25 V;

Step 10: Charge the battery with a constant current of 2C until the voltage of the battery reaches 4.45 V;

Step 11: Charge the battery with a constant current of 1.4C until the current of the battery reaches $U_{m+1}$;

Step 12: Continue to charge the battery with a constant voltage of $U_{m+1}$ until the current of the battery reaches a cut-off current of 0.25C;

Step 13: Leave the battery standing for 1 minute, and collect the open-circuit voltage $OCV_{m+1}$ of the battery that has been standing for 1 minute;

Step 14: Then discharge the battery with a constant current of 1.0C until the voltage of the battery reaches 3.0 V; and

Step 15: Repeat step 8 to step 14 for 500 cycles, with 1 added to m automatically after each cycle.

**Example 2**

It should be noted that, in Example 2, a fresh battery is selected for obtaining the parameter, open-circuit voltage $OCV_n$, by using the same method as in Example 1, where $OCV_n$ = 4.47 V. For a specific obtaining process, refer to Example 1. Details are not described herein again.

The charging and discharging process is as follows:
Ambient temperature: 25°C

Step 1: Charge the battery with a constant current of 3C until a voltage of the battery reaches 4.25 V;

Step 2: Charge the battery with a constant current of 2C until the voltage of the battery reaches 4.45 V;

Step 3: Charge the battery with a constant current of 1.4C until the voltage of the battery reaches $U_n$, where in this case, $U_n$ = 4.5 V;

Step 4: Continue to charge the battery with a constant voltage of 4.5 V until the current of the battery reaches a cut-off current of 0.25C;

Step 5: Leave the battery standing for 1 minute, and collect the open-circuit voltage $OCV_m$ of the battery that has been standing for 1 minute;

Step 6: Then discharge the battery with a constant current of 1.0C until the voltage of the battery reaches 3.0 V;

Step 7: Then leave the battery standing for 1 minute again;

Step 8: Calculate a cut-off voltage $U_{m+1}$ of a next battery constant voltage charging, where $U_{m+1} = U_n + k \times (OCV_n - OCV_m)$, $U_n$ = 4.5 V, $OCV_n$ = 4.47 V, and k=0.8;

Step 9: Charge the battery with a constant current of 3C until the voltage of the battery reaches 4.25 V;

Step 10: Charge the battery with a constant current of 2C until the voltage of the battery reaches 4.45 V;

Step 11: Charge the battery with a constant current of 1.4C until the current of the battery reaches $U_{m+1}$;

Step 12: Continue to charge the battery with a constant voltage of $U_{m+1}$ until the current of the battery reaches a cut-off current of 0.25C;

Step 13: Leave the battery standing for 1 minute, and collect the open-circuit voltage $OCV_{m+1}$ of the battery that has been standing for 1 minute;

Step 14: Then discharge the battery with a constant current of 1.0C until the voltage of the battery reaches 3.0 V; and

Step 15: Repeat step 8 to step 14 for 500 cycles, with 1 added to m automatically after each cycle.

**Example 3**

It should be noted that, in Example 2, a fresh battery is selected for obtaining the parameter, open-circuit voltage $OCV_n$, by using the same method as in Example 1, where $OCV_n$ = 4.47 V. For a specific obtaining process, refer to Example 1. Details are not described herein again.

The charging and discharging process is as follows:

Step 1: Charge the battery with a constant current of 3C until a voltage of the battery reaches 4.25 V;

Step 2: Charge the battery with a constant current of 2C until the voltage of the battery reaches 4.45 V;

Step 3: Charge the battery with a constant current of 1.4C until the voltage of the battery reaches $U_n$, where in this case, $U_n$ = 4.5 V;

Step 4: Continue to charge the battery with a constant voltage of 4.5 V until the current of the battery reaches a cut-off current of 0.25C;

Step 5: Leave the battery standing for 1 minute, and collect the open-circuit voltage $OCV_m$ of the battery that has been standing for 1 minute;

Step 6: Then discharge the battery with a constant current of 1.0C until the voltage of the battery reaches 3.0 V;

Step 7: Then leave the battery standing for 1 minute again;

Step 8: Calculate a cut-off voltage $U_{m+1}$ of a next battery constant voltage charging, where $U_{m+1} = U_n + k \times (OCV_n - OCV_m)$, $U_n$ = 4.5 V, $OCV_n$ = 4.47 V, and k=1;

Step 9: Charge the battery with a constant current of 3C until the voltage of the battery reaches 4.25 V;

Step 10: Charge the battery with a constant current of 2C until the voltage of the battery reaches 4.45 V;

Step 11: Charge the battery with a constant current of 1.4C until the current of the battery reaches $U_{m+1}$;

Step 12: Continue to charge the battery with a constant voltage of $U_{m+1}$ until the current of the battery reaches a cut-off current of 0.25C;

Step 13: Leave the battery standing for 1 minute, and collect the open-circuit voltage $OCV_{m+1}$ of the battery that has been standing for 1 minute;

Step 14: Then discharge the battery with a constant current of 1.0C until the voltage of the battery reaches 3.0 V; and

Step 15: Repeat step 8 to step 14 for 500 cycles, with 1 added to m automatically after each cycle.

Constant voltages (CVs), charge cut-off SOCs and charge times of the battery during cycling in Comparative Examples 1 and 2 and Examples 1 to 3 are recorded in Table 1. It should be noted that, C is a charge/discharge rate, the charge/discharge rate refers to a current required for charging to a rated capacity or discharging the rated capacity within a specified time, and it is numerically equal to charge/discharge current/rated capacity of battery. For example, when the rated capacity is 10 Ah and the battery discharges at 2 A, a discharge rate of the battery is 0.2C; and when the battery discharges at 20 A, the discharge rate of the battery is 2C.

**Table 1 Test results of Examples 1 to 3 and Comparative Examples 1 and 2**

| | Value of n | Value of (m+1) | Constant voltage (V) | Charge cut-off SOC | Charge time (min) |
|---|---|---|---|---|---|
| Comparative Example 1 | 1 | 3 | 4.5 | 100.0% | 41.1 |
| | 1 | 100 | 4.5 | 99.6% | 41.3 |
| | 1 | 200 | 4.5 | 99.2% | 41.6 |
| | 1 | 500 | 4.5 | 98.0% | 42.4 |
| Comparative Example 2 | 1 | 3 | 4.5,4.45 | 100.0% | 46.2 |
| | 1 | 100 | 4.5, 4.45 | 99.9% | 48.3 |
| | 1 | 200 | 4.5, 4.45 | 99.8% | 50.5 |
| | 1 | 500 | 4.5, 4.45 | 99.5% | 57.8 |
| Example 1 (k = 0.5) | 1 | 3 | 4.5000 | 100.0% | 41.1 |
| | 1 | 100 | 4.5013 | 99.8% | 41.4 |
| | 1 | 200 | 4.5025 | 99.6% | 41.7 |
| | 1 | 500 | 4.5063 | 99.0% | 42.6 |
| Example 2 (k = 0.8) | 1 | 3 | 4.5000 | 100.0% | 41.1 |
| | 1 | 100 | 4.5020 | 99.9% | 41.5 |
| | 1 | 200 | 4.5040 | 99.8% | 41.8 |
| | 1 | 500 | 4.5100 | 99.5% | 42.8 |

(continued)

|  | Value of n | Value of (m+1) | Constant voltage (V) | Charge cut-off SOC | Charge time (min) |
|---|---|---|---|---|---|
| Example 3 (k = 1) | 1 | 3 | 4.5000 | 100.0% | 41.1 |
| | 1 | 100 | 4.5025 | 100.0% | 41.6 |
| | 1 | 200 | 4.5050 | 100.0% | 42.0 |
| | 1 | 500 | 4.5125 | 100.0% | 43.0 |

It can be learned from Table 1 that, in the charging method in Comparative Example 1, with the cycling of the battery, impedance of the battery gradually increases, the charge cut-off SOC gradually decreases, and the charging time gradually increases. Comparative Example 2 aims to resolve the problem with Comparative Example 1 that with the use of the battery, the charge cut-off SOC gradually decreases. It can be learned from the results in Table 1 that, the charge cut-off SOC in Comparative Example 2 is obviously increased compared with Comparative Example 1, and the charge time is, however, greatly prolonged compared with Comparative Example 1.

Examples 1 to 3 can substantially resolve the problem with Comparative Example 1 that with the use of the battery, the charge cut-off SOC decreases. Here, values of k in Examples 1 to 3 are respectively 0.5, 0.8, and 1. It can be learned from the results in Table 1 that, as the value of k increases, the charge cut-off SOC gradually increases during the cycling. When k = 0.8, using the charging method provided by this application can achieve the same charge cut-off SOC as in Comparative Example 2. When k = 1, using the charging method provided in this application allows the charge cut-off SOC to be always the same as that of the fresh battery (fresh battery), meaning that the battery can be fully charged. Although the corresponding charge time is slightly prolonged compared with Comparative Example 1, it is basically negligible. The fresh battery is a battery that has just left factory and that has not been cycled, or a battery with the number of charge-discharge cycles less than a preset number (for example, 10 or other numbers) after the battery leaves factory.

Therefore, in this application, the charge cut-off voltage of the battery in the charging process is reduced based on the actual aging state of the battery, so as to resolve the problem that with the cycling of a battery, impedance of the battery increases, and the battery cannot be fully charged by using a charging method with a relatively large charge cut-off current. The charging method provided in this application can not only meet a requirement for fully charging a battery, but also shorten the time required for charging the battery to a full charge state, so as to improve user experience.

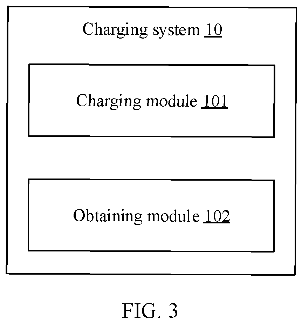

Referring to FIG. 3, in this embodiment, the charging system 10 may be divided into one or more modules, where the one or more modules may be stored in the processor 12, and the processor 12 executes the charging method in the embodiments of this application. The one or more modules may be a series of computer program instruction segments capable of completing particular functions, where the instruction segments are used to describe a process of execution by the charging system 10 in the electronic apparatus 1. For example, the charging system 10 may be divided into a charging module 101 and an obtaining module 102 in FIG. 3.

The charging module 101 is configured to: in an n-th charging process, charge a first battery to a charge cut-off voltage $U_n$ in a charging manner, where n is a positive integer greater than 0; the obtaining module 102 is configured to: after the n-th charging process is completed, leave the first battery standing, and obtain an open-circuit voltage $OCV_n$ of the first battery at a standing time of $t_i$; the charging module 101 is further configured to: in an m-th charging process, charge the first battery to the charge cut-off voltage $U_n$ in the charging manner, where m is a positive integer, and m > n; the obtaining module 102 is further configured to: after the m-th charging process is completed, leave the first battery standing, and obtain an open-circuit voltage $OCV_m$ of the first battery at the standing time of $t_i$; and the charging module 101 is further configured to: under the condition of $OCV_n > OCV_m$, in an (m+1)-th charging process and subsequent charging processes, charge the first battery to a first charge cut-off voltage $U_{m+1}$ in the charging manner, where $U_{m+1} = U_n + k \times (OCV_n - OCV_m)$, and $0 < k \leq 1$.

With the charging system 10, the charge cut-off voltage of the battery in the charging process can be increased, so as to resolve the problem that with the cycling of a battery, impedance of the battery increases, and full charging cannot be implemented by using a charging method with a relatively large charge cut-off current. For specific content, reference may be made to the foregoing embodiments of the charging method for battery. Details are not described herein again.

In an embodiment, the processor 12 may be a central processing unit (Central Processing Unit, CPU), or may be other general-purpose processors, digital signal processors (Digital Signal Processor, DSP), application-specific integrated circuits (Application Specific Integrated Circuit, ASIC), field programmable gate arrays (Field-Programmable Gate Array, FPGA) or other programmable logic devices, discrete gates or transistor logic devices, discrete hardware components, or the like. The general-purpose processor may be a microprocessor, or the processor 12 may be any other conventional processors or the like.

If implemented in a form of software functional units and sold or used as separate products, the modules in the charging system 10 may be stored in a computer-readable storage medium. Based on this understanding, all or part of the processes of the method in the embodiments of this application may be implemented by a computer program instructing related hardware. The computer program may be stored in the computer-readable storage medium, and when the computer program is executed by a processor, the steps in the foregoing method embodiments may be implemented. The computer program includes computer program code, where the computer program code may be source code, object code, an executable file, some intermediate forms, or the like. The computer-readable medium may include: any entity or apparatus capable of carrying the computer program code, a recording medium, a USB flash disk, a mobile hard disk, a diskette, a compact disc, a computer memory, a read-only memory (ROM, Read-Only Memory), a random access memory (RAM, Random Access Memory), or the like.

It can be understood that the unit division described above is based on logical functions, and division in other manners may be used during actual implementation. In addition, in the embodiments of this application, all the functional modules may be integrated into a same processing unit, or each module may exist alone physically, or two or more modules may be integrated into a same unit. The integrated module may be implemented in a form of hardware, or may be implemented in a form of hardware and software functional modules.

The one or more modules may alternatively be stored in the memory and executed by the processor 12. The memory 11 may be an internal storage device of the electronic apparatus 1, that is, a storage device built in the electronic apparatus 1. In other embodiments, the memory 11 may alternatively be an external storage device of the electronic apparatus 1, that is, a storage device externally connected to the electronic apparatus 1.

In some embodiments, the memory 11 is configured to: store program code and various data, for example, program code of the charging system 10 installed on the electronic apparatus 1; and implement high-speed automatic access to programs or data during running of the electronic apparatus 1.

The memory 11 may include a random access memory, and may also include a non-volatile memory, for example, a hard disk, an internal memory, a plug-in hard disk, a smart media card (Smart Media Card, SMC), a secure digital (Secure Digital, SD) card, a flash card (Flash Card), or at least one disk storage device, flash memory device, or other volatile solid-state storage device.

It is apparent for persons skilled in the art that this application is not limited to the details of the foregoing illustrative embodiments, and can be implemented in other specific forms without departing from the spirit or basic features of this application. Therefore, the foregoing embodiments of this application shall, in whatever aspect, be considered as being illustrative rather than limitative. The scope of this application is defined by the appended claims rather than the above description, and therefore all variations falling within the meaning and scope of the claims and their equivalents are intended to be encompassed in this application.

## Claims

1. A charging method for battery, **characterized in that** the method comprises:

   in an n-th charging process, charging a first battery to a charge cut-off voltage $U_n$ in a charging manner, wherein n is a positive integer greater than 0;
   after the n-th charging process is completed, leaving the first battery standing, and obtaining an open-circuit voltage $OCV_n$ of the first battery at a standing time of $t_i$;
   in an m-th charging process, charging the first battery to the charge cut-off voltage $U_n$ in the charging manner, wherein m is a positive integer, and m > n;
   after the m-th charging process is completed, leaving the first battery standing, and obtaining an open-circuit voltage $OCV_m$ of the first battery at the standing time of $t_i$; and
   under the condition of $OCV_n > OCV_m$, in an (m+1)-th charging process and subsequent charging processes, charging the first battery to a first charge cut-off voltage $U_{m+1}$ in the charging manner, wherein $U_{m+1} = U_n + k \times (OCV_n - OCV_m)$, and $0 < k \leq 1$.

2. The charging method according to claim 1, **characterized in that**
   the open-circuit voltage $OCV_n$ comprises a pre-stored open-circuit voltage of a second battery collected at the standing time of $t_i$ in the standing process that follows completion of the n-th charging process, wherein the first battery and the second battery are different batteries in a same battery system.

3. The charging method according to claim 1, **characterized by** further comprising:
   under the condition of $OCV_n \leq OCV_m$, in the (m+1)-th charging process and the subsequent charging processes, charging the first battery to the charge cut-off voltage $U_n$ in the charging manner.

4. The charging method according to claim 1, **characterized in that** the method further comprises:

in an (m+b)-th charging process, charging the first battery to the first charge cut-off voltage $U_{m+1}$ in the charging manner, wherein b is a positive integer greater than 1;
after the (m+b)-th charging process is completed, leaving the first battery standing, and obtaining an open-circuit voltage $OCV_{m+b}$ of the first battery at the standing time of $t_i$; and
under the condition of $OCV_n > OCV_{m+b}$, in an (m+b+1)-th charging process and subsequent charging processes, charging the first battery to a second charge cut-off voltage $U_{m+b+1}$ in the charging manner, wherein $U_{m+b+1} = U_{m+1} + k \times (OCV_n - OCV_{m+b})$, and $0 < k \leq 1$.

5. The charging method according to claim 4, **characterized in that** the method further comprises:
under the condition of $OCV_n \leq OCV_{m+b}$, in the (m+b+1)-th charging process and the subsequent charging processes, charging the first battery to the first charge cut-off voltage $U_{m+1}$ in the charging manner.

6. The charging method according to any one of claims 1 to 5, **characterized in that** $U_{cl} \leq U_n \leq U_{cl}+500$ mV, wherein $U_{cl}$ is a limited charge voltage of a battery system to which the first battery belongs.

7. The charging method according to claim 1, **characterized in that** the charging manner comprises N charging stages in sequence, wherein N is a positive integer greater than 1, and in the N-th charging stage, the first battery is charged constantly with the constant charge cut-off voltage.

8. The charging method according to claim 1, **characterized in that** the charging manner further comprises M constant-current charging stages in sequence, wherein M is a positive integer greater than 1, and in the constant-current charging stages, after a voltage of the first battery reaches the charge cut-off voltage $U_n$, each of the subsequent constant-current charging stages is cut off by using the charge cut-off voltage $U_n$.

9. The charging method according to claim 8, **characterized in that** the M constant-current charging stages are each defined as a k-th charging stages, with k=1, 2, ..., M, wherein a charge current of the (k+1)-th charging stage is less than a charge current of the k-th charging stage.

10. An electronic apparatus, **characterized by** comprising:

a battery; and
a processor, configured to execute the charging method according to any one of claims 1 to 9, to charge the battery.

11. A storage medium, storing at least one computer instruction, **characterized in that** the instruction is loaded by a processor to execute the charging method according to any one of claims 1 to 9.

Electronic apparatus 1

Memory 11

Charging system 10

Processor 12

Battery 13

FIG. 1

Start

In an n-th charging process, charge a first battery to its charge cut-off voltage $U_n$ in a charging manner, where n is a positive integer greater than 0 — S1

After the n-th charging process is completed, leave the first battery standing, and obtain an open-circuit voltage $OCV_n$ of the first battery at a standing time of $t_i$ — S2

In an m-th charging process, charge the first battery to the charge cut-off voltage $U_n$ in the charging manner, where m is a positive integer, and m > n — S3

After the m-th charging process is completed, leave the first battery standing, and obtain an open-circuit voltage $OCV_m$ of the first battery at the standing time of $t_i$ — S4

S5

$OCV_n > OCV_m$

Compare the open-circuit voltage $OCV_n$ with the open-circuit voltage $OCV_m$ by magnitude

$OCV_n \leq OCV_m$

In an (m+1)-th charging process and subsequent charging processes, charge the first battery to a first charge cut-off voltage $U_{m+1}$ in the charging manner — S6

In the (m+1)-th charging process and the subsequent charging processes, charge the first battery to the charge cut-off voltage $U_n$ in the charging manner — S7

End

FIG. 2

Charging system 10

Charging module 101

Obtaining module 102

FIG. 3

## INTERNATIONAL SEARCH REPORT

| | International application No. |
| --- | --- |
| | **PCT/CN2020/139214** |

| A. | CLASSIFICATION OF SUBJECT MATTER |
| --- | --- |

H02J 7/00(2006.01)i; H01M 10/44(2006.01)i

According to International Patent Classification (IPC) or to both national classification and IPC

| B. | FIELDS SEARCHED |
| --- | --- |

Minimum documentation searched (classification system followed by classification symbols)

H02J; H01M

Documentation searched other than minimum documentation to the extent that such documents are included in the fields searched

Electronic data base consulted during the international search (name of data base and, where practicable, search terms used)

CNABS, CNTXT, DWPI, SIPOABS, CNKI: 电池, 充电, 截止电压, 开路电压, 静置, 老化, battery, charge, cut-off voltage, open circuit voltage, OCV, stand, aging

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 111384757 A (GUANGDONG OPPO MOBILE TELECOMMUNICATIONS CORP., LTD.) 07 July 2020 (2020-07-07)<br>description, paragraphs 22-106, figures 1-5 | 1-11 |
| A | CN 103956530 A (SHANGHAI ADVANCED RESEARCH INSTITUTE, CHINESE ACADEMY OF SCIENCES) 30 July 2014 (2014-07-30)<br>entire document | 1-11 |
| A | CN 111446750 A (OPPO GUANGDONG MOBILE COMMUNICATIONS CO., LTD.) 24 July 2020 (2020-07-24)<br>entire document | 1-11 |
| A | US 8198863 B1 (MAXIM INTEGRATED PROD INC) 12 June 2012 (2012-06-12)<br>entire document | 1-11 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 September 2021** | **29 September 2021** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

| | International application No. |
|---|---|
| | **PCT/CN2020/139214** |

| Patent document<br>cited in search report | | | Publication date<br>(day/month/year) | Patent family member(s) | | | Publication date<br>(day/month/year) |
|---|---|---|---|---|---|---|---|
| CN | 111384757 | A | 07 July 2020 | None | | | |
| CN | 103956530 | A | 30 July 2014 | CN | 103956530 | B | 20 January 2016 |
| CN | 111446750 | A | 24 July 2020 | None | | | |
| US | 8198863 | B1 | 12 June 2012 | None | | | |

Form PCT/ISA/210 (patent family annex) (January 2015)